(19) Europäisches Patentamt
European Patent Office
Office européen des brevets

(11) **EP 0 588 992 B1**

## (12) EUROPÄISCHE PATENTSCHRIFT

(45) Veröffentlichungstag und Bekanntmachung des Hinweises auf die Patenterteilung:
**16.04.1997 Patentblatt 1997/16**

(21) Anmeldenummer: **93900014.7**

(22) Anmeldetag: **09.06.1992**

(51) Int Cl.[6]: **H01J 37/32**

(86) Internationale Anmeldenummer:
**PCT/DE92/00471**

(87) Internationale Veröffentlichungsnummer:
**WO 92/22920 (23.12.1992 Gazette 1992/32)**

(54) **VORRICHTUNG ZUR PLASMAUNTERSTÜTZTEN BEARBEITUNG VON SUBSTRATEN**

DEVICE FOR PROCESSING SUBSTRATES WITHIN A PLASMA

DISPOSITIF DE TRAITEMENT DE SUBSTRATS DANS DU PLASMA

(84) Benannte Vertragsstaaten:
**CH DE FR GB IT LI NL**

(30) Priorität: **08.06.1991 DE 4118973**

(43) Veröffentlichungstag der Anmeldung:
**30.03.1994 Patentblatt 1994/13**

(73) Patentinhaber: **FRAUNHOFER-GESELLSCHAFT ZUR FÖRDERUNG DER ANGEWANDTEN FORSCHUNG E.V.**
**80636 München (DE)**

(72) Erfinder:
• **HEINRICH, Friedhelm**
**D-1000 Berlin 41 (DE)**

• **HOFFMANN, Peter**
**D-1000 Berlin 21 (DE)**

(74) Vertreter: **Münich, Wilhelm, Dr.**
**Kanzlei Münich, Steinmann, Schiller**
**Wilhelm-Mayr-Str. 11**
**80689 München (DE)**

(56) Entgegenhaltungen:
**EP-A- 0 228 865**

• **IBM TECHNICAL DISCLOSURE BULLETIN. Bd. 26, Nr. 2, Juli 1983, NEW YORK US Seiten 866 - 869; R.F. BROOM ET AL.: 'Control of the uniformity of thin films formed by an RF plasma.'**
• **PATENT ABSTRACTS OF JAPAN vol. 13, no. 581 (E-865)21. Dezember 1989 & JP-A-1 244 619**

## Beschreibung

### Technisches Gebiet

Die Erfindung bezieht sich auf eine Vorrichtung zur plasmaunterstützten Bearbeitung von Substraten, mit einem Rezipienten, in dem im Plasma gebildete Ionen und reaktive Neutralteilchen (Radikale) auf das Substrat einwirken.

Derartige Vorrichtungen zur plasmaunterstützten Bearbeitung werden sowohl zum Abtragen als auch zum Auftragen von Material von bzw. auf Halbleiter-, Metall, Glas- oder Kunststoffsubstrate verwendet.

Der in derartigen Vorrichtungen durchgeführte Bearbeitungsvorgang beruht auf einem kombinierten Angriff der im Plasma gebildeten Ionen und der reaktiven Neutralteilchen (Radikale). Während die Neutralteilchen im wesentlichen mit thermischer Geschwindigkeit und mit isotroper Richtungsverteilung auf das Substrat (Wafer) auftreffen, erreichen die Ionen den Wafer mit relativ hoher kinetischer Energie und starker Vorzugsorientierung.

### Stand der Technik

Aus einer Reihe von Veröffentlichungen, beispielsweise der DE 39 13 463 A1 oder der DE 38 01 205 C1 ist es bekannt, bei plasmaunterstützten Bearbeitungsvorgängen, wie z.B. beim Trockenätzen oder bei der Schichtabscheidung zusätzlich Magnetfelder zu verwenden.

Ergänzend wird auf die Veröffentlichungen "Magnetically Enhanced Plasma Deposition und Etching" in Solid State Technology, April 1987, S.99-104, "A magnetic multipole reactor for high-flux reactive ion etching" in J.Appl. Phys.$\underline{63}$ (6), S.1899-1903, und auf "RF-broad-beam ion source for reactive sputtering" in Vacuum, 1986, S. 973-976 verwiesen.

Bei diesen bekannten Vorrichtungen werden die Magnetfelder mit dem Ziel verwendet, die Elektronen möglichst lange im Plasma zu halten und damit deren Dichte und Stoßwahrscheinlichkeit zu erhöhen. Auf diese Weise erreicht man eine Erhöhung der Ionenproduktion sowie eine gewisse Erhöhung der Radikalenproduktion. Ferner könndn die Magnetfelder dazu verwandt werden, das Volumen des Plasmas im Rezipienten derart zu steuern, daß nur die im Plasma gebildeten reaktiven Neutralteilchen zum Substrat gelangen können.

### Beschreibung der Erfindung

Erfindungsgemäß ist nun erkannt worden, daß bei Vorrichtungen zur plasmaunterstützten Bearbeitung von Substraten, mit einem Rezipienten, in dem im Plasma gebildete Ionen und reaktive Neutralteilchen (Radikale) auf das Substrat einwirken, das Bearbeitungsergebnis nicht nur von den Absolutwerten der Ionen- und Radikalenstromdichten auf der Oberfläche des Substrats, sondern auch vom Verhältnis r von Ionen- zu Radikalenstromdichten $r=j_{ion}/j_{rad}$ bestimmt wird.

Bei den bekannten Vorrichtungen zur plasmaunterstützten Bearbeitung von Substraten, mit einem Rezipienten, in dem im Plasma gebildete Ionen und reaktive Neutralteilchen auf das Substrat einwirken, wie sie beispielsweise aus den vorstehend genannten Druckschriften bekannt sind, ist eine gezielte Einstellung der Ionen- und Radikalenstromdichten dagegen nicht möglich.

Der Erfindung liegt die Aufgabe zugrunde, eine Vorrichtung zur plasmaunterstützten Bearbeitung von Substraten, mit einem Rezipienten, in dem im Plasma gebildete Ionen und reaktive Neutralteilchen (Radikale) auf das Substrat einwirken, anzugeben, bei der die Ionen- und Radikalenstromdichten weitgehend unabhängig voneinander einstellbar sind.

Eine erfindungsgemäße Lösung dieser Aufgabe ist im Anspruch 1 angegeben. Weiterbildungen der Erfindung sind in den Unteransprüchen gekennzeichnet.

Erfindungsgemäß wird deshalb eine Vorrichtung zur plasmaunterstützten Bearbeitung von Substraten dadurch weitergebildet, daß zur Steuerung der Absolutwerte der Ionen- und Radikalenstromdichten und zur Steuerung der relativen Verhältnisse von Ionen- zu Radikalenstromdichten auf der Oberfläche des Substrats Mittel zur Variation des Plasmavolumens vorgesehen sind.

Die Erfindung geht dabei von dem Grundgedanken aus, durch eine gezielte Variation des Plasmavolumens beispielsweise durch den Einsatz bestimmter Magnetfeldkonfigurationen oder der Rezipientengeometrie die einzelnen Stromdichten einzustellen.

Die erfindungsgemäße Vorrichtung ermöglicht damit eine Erhöhung der Absolutstromdichten von Ionen und Radikalen (chemisch reaktiven Neutralteilchen) sowie eine kontrollierte Einstellung der Stromverhältnisse r.

### Kurze Beschreibung der Zeichnung

Die Erfindung wird nachstehend anhand von Ausführungsbeispielen unter Bezugnahme auf die Zeichnung exemplarisch beschrieben, auf die im übrigen bezüglich der Offenbarung aller im Text nicht näher erläuterten erfindungsgemäßen Einzelheiten ausdrücklich verwiesen wird. Es zeigen:

Fig. 1            einen Längsschnitt durch eine gattungsgemäße Vorrichtung zur Erläuterung der der Erfindung zugrun deliegenden Prinzipien,

Fig. 2a bis 2c   Varianten eines ersten Ausführungsbeispiels,

Fig. 3           ein zweites Ausführungsbeispiel,

Fig. 4           ein drittes Ausführungsbeispiel, und

Fig. 5a und 5b   eine Erläuterung der mit einer erfindungsgemäßen Vorrichtung möglichen Betriebsarten.

## Beschreibung von Ausführungsbeispielen

In der folgenden Beschreibung werden für gleiche Teile immer die selben Bezugszeichen verwendet, so daß auf eine erneute Vorstellung dieser Teile verzichtet wird.

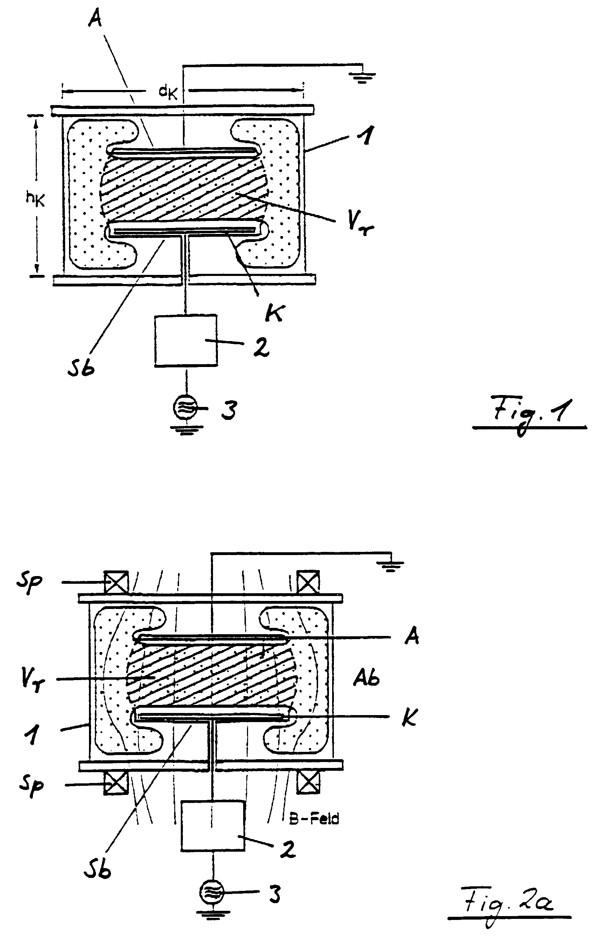

Fig. 1 zeigt zur Erläuterung der erfindungsgemäßen Grundprinzipien eine Vorrichtung zur plasmaunterstützten Bearbeitung von Substraten in einen Rezipienten 1, der beispielsweise eine zylindrische Kammer mit der Innenhöhe $h_K$ und dem Durchmesser $d_K$ sein kann. In dem Rezipienten 1 ist eine Elektrode K (Kathode) angeordnet, die über ein Anpassungsnetzwerk 2 mit einer Hochfrequenz-Leistungsquelle 3 verbunden ist. Mit A sind eine Gegenelektrode (Anode), die mit Bezugspotential verbunden ist, und mit Sb das zu bearbeitende Substrat bezeichnet.

Bei den in Fig. 1 dargestellten Vorrichtungen, wie sie aus dem Stand der Technik bekannt sind, stellen sich i.a. sowohl das Plasmavolumen als auch die Stromdichten j der Ionen und Radikalen in Richtung auf das Substrat Sb je nach Wahl der Prozeßbedingungen (z.B. Reaktorgeometrie, Prozeßdruck, Gasfluß, eingekoppelte Leistung) mehr oder weniger selbsttätig ein.

Im folgenden sollen die Konsequenzen erläutert werden, die sich durch die erfindungsgemäß vorgesehene Variation des Plasmavolumens für die Ionen- und Radikalenstromdichten auf das Substrat Sb ergeben:

Die Bilanzgleichung für die Produktions- und Verlustraten werden durch die Kontinuitätsgleichung

$$\text{div } j = P \tag{1}$$

beschrieben, wobei P die Produktionsrate für Ionen und Radikale im Plasmavolumen und j die Stromdichte der aus einem Volumenelement abfließenden Teilchen bedeuten.

Die Integration der Gleichung 1 liefert bei im Plasmavolumen $V_p$ konstanter Produktionsrate P, wenn die Verluste im Volumen zunächst vernachlässigt werden, folgende Gleichung

$$\int_J j \ dA \ = \ P \ V_p \tag{2}$$

wobei die Integration über die gesamte Plasmaoberfläche $A_p$ läuft.

Bei der Integration der Gleichung (2) sind zwei Fälle zu unterscheiden:

(1) Bei kleinen Drücken bzw. hohen Leistungen wird sich das Plasma unabhängig von der speziellen Anordnung der Elektroden K und A auf nahezu das gesamte Kammervolumen $V_p = V = h_K \ast d_K{}^2/4$ ausdehnen. Für Ionen- und Neutralteilchen sind die Verlustoberflächen in diesem Fall gleich der Kammeroberfläche A. Die Ionen- bzw. Radikalenstromdichten werden dann

$$j^{ion} = p^{ion} \ V/A \tag{3}$$

$$j^{rad} = p^{rad} \ V/A^{rad} \tag{4}$$

$A^{rad}$ ist eine effektive Verlustoberfläche, die von der Geometrie und der Materialbeschaffenheit der Kammer sowie von der Pumpleistung abhängig ist.

(2) Wird das Plasmavolumen $V_p$ auf einen Bereich $V_r$ kleiner als das Kammervolumen V reduziert (dieser Fall ist mit dem Index r bezeichnet) dann gilt für die Ionenstromdichten bei konstantem P

EP 0 588 992 B1

$$J_r ion = P_r ion V_r / A_r \qquad (5)$$

Für die neutralen Teilchen gilt die Beziehung

$$j_r rad = P_r rad\ V_r / A^{rad} \qquad (6)$$

Diese Gleichung berücksichtigt, daß Neutralteilchen im wesentlichen an den Kammerwänden verlorengehen. $A^{rad}$ ändert sich daher bei Reduzierung des Plasmavolumens nicht. Die Änderung der Ionenstromdichten folgt dann aus den Gleichungen (3) und (5), die der Radikalen, d.h. der reaktiven Neutralteilchen aus den Gleichungen (4) und (6).

Wenn man annimmt, daß sich die Produktionsraten für Ionen und Radikale vergleichbar verhalten, dann ergeben sich die Stromverhältnisse und deren Änderung a zu

$$a = j_r{}^{ion}/j_r{}^{rad}) : (j^{ion} / j^{rad}) = A/A_r \qquad (7)$$

d.h. die Stromverhältnisse ändern sich wie die Verhältnisse der für den Abtransport der Ionen verantwortlichen Plasmaoberflächen.

Bei einer Einschnürung des Plasmas, das im günstigsten Fall auf den Bereich der Elektroden K und A beschränkt ist, erhöht sich der Gesamtionenstrom auf die Substratoberfläche als Folge der Leistungsdichteerhöhung und der verminderten Wandverluste bei konstanter Gesamtleistung. Die Radikalenstromdichte erhöht sich nicht in dem selben Maße.

Das Verhältnis $r = j_{ion}/j_{rad}$ der Stromdichten auf dem Substrat Sb erhöht sich um den Faktor $A/A_r$, wobei A die Gesamtoberfläche, die durch die Kammerwände und die Substratoberfläche bestimmt ist, und $A_r$ die reduzierte Verlustoberfläche für die Ionen bedeuten.

Die reduzierte Verlustoberfläche $A_r$ für die Ionen ist bei einer Einschnürung zwischen die Elektroden K und A (gestrichelter Bereich in Fig. 1) gleich der zweifachen Elektrodenoberfläche, da nach den Seiten keine Ionen abfließen können. Wird z.B. eine Kammer mit der Höhe $h_K = 20cm$ und mit dem Durchmesser $d_K = 50cm$ und ein Substrat mit einem Durchmesser $d_W = 20cm$ (8" Wafer) verwendet, dann ergibt sich eine Variationsbreite des Verhältnisses der Stromdichten von Ionen und Neutralteilchen von mehr als 20 (!) durch Steuerung des Plasmavolumens.

Dies ist insbesondere bei der anisotropen Strukturierung von Vorteil, bei der hohe Ionenstromdichten im Vergleich zu den Radikalenstromdichten erwünscht sind.

Im folgenden sollen Vorrichtungen zur plasmaunterstützten Bearbeitung von Substraten beschrieben werden, bei denen je nach Anwendung bzw. angestrebtem Verhältnis von Ionen- zu Radikalenstromdichten bestimmte Plasmavolumina bzw. -oberflächen durch geeignete Magnetfeld/ Rezipientenkonfigurationen realisiert werden.

In den folgenden Figuren sind jeweils gleiche oder entsprechende Teile wie in Fig. 1 mit den selben Bezugszeichen bezeichnet, so daß auf eine erneute Vorstellung verzichtet wird, und lediglich die Abweichungen der in diesen Figuren dargestellten Ausführungsbeispiele gegenüber dem ersten Ausführungsbeispiel erläutert werden:

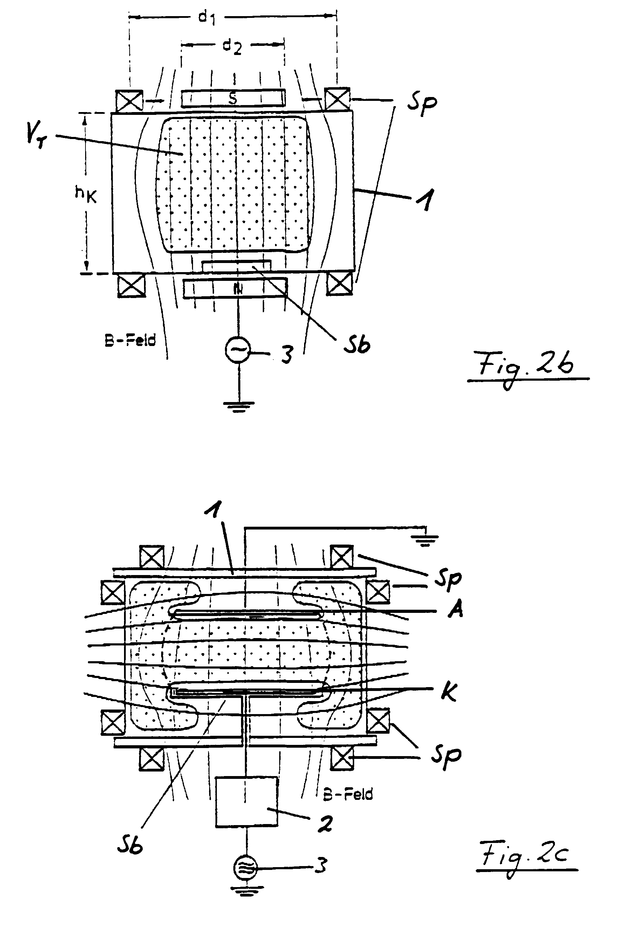

Die Fig. 2a bis 2c zeigen Varianten eines ersten Ausführungsbeispiels, bei dem der Anteil der positiven Ionenstromdichten erhöht wird. Hierzu sind Magnetfelder vorgesehen, die durch Elektromagnete Sp (Fig. 2a) oder durch sich gegenüberliegende Permanentmagnete erzeugt werden.

Diese Konfiguration läßt sich mit besonderem Vorteil einsetzen, wenn der Anteil ioneninduzierter Oberflächenprozesse verstärkt werden soll, wie dies z.B. bei der anisotrope Strukturübertragung (Ätzen) oder der ioneninduzierten Deposition etc. der Fall ist.

Die Wirkung des durch die Magnete Sp hervorgerufenen Magnetfeldes (B-Feld) ist folgende:

Die Elektronendiffusion senkrecht zu den B-Feldlinien ist begrenzt, so daß auch die positiven Ionen mit verminderten Stromdichten in dieser Richtung austreten. Dadurch werden bei ausreichend hohen B-Feldern die Elektronen und damit auch die Ionen im reduzierten Volumen $V_r$ gehalten. Durch eine Variation des Magnetfeldes B, z.B. durch Veränderung der Spulenströme oder der verwendeten Permanentmagnetanordnung, läßt sich $V_r$ und damit das Verhältnis r von Ionen- zu Radikalen-stromdichten einstellen. Die maximal einstellbaren Stromdichteverhältnisse r sind - wie bereits ausgeführt - durch die Substratoberflächen bestimmt.

Die Einschnürung des Plasmas wird bei dem in Fig. 2a gezeigten Ausführungsbeispiel durch konzentrisch zu den Elektroden K und A angebrachte Spulen Sp erreicht. Verwendet man z.B. Spulen in Helmholtzkonfiguration, so erhält man im gesamten Plasmabereich eine homogene B-Feldverteilung. Die Magnetfeldlinien stehen senkrecht auf den Elektroden(Substrat)oberfläche. Dadurch wird die radiale Diffusion behindert. Je nach eingestellter Magnetfeldstärke kann so das Plasmavolumen verändert werden.

Ferner ist es möglich, den Abstand Ab der Elektroden K und A zu variieren. Hierdurch ergibt sich eine zusätzliche Variation der Plasmazusammensetzung und der Ströme. Insbesondere läßt sich durch eine Verringerung des Elektrodenabstandes die Leistungsdichte im Plasmavolumen bei konstanter eingespreister Gesamtleistung sehr stark steigern. Das Plasma kann durch die magne-tischen Felder auch bei hohen Leistungsdichten und kleinen Drücken (!) zwischen den Elektroden gehalten werden.

Ausdrücklich wird darauf hingewiesen, daß es nicht von Belang ist, wie die Magnetfelder erzeugt werden.

Wie Fig. 2b zeigt, kann das gleiche Ergebnis z.B. auch durch in die Elektroden integrierte Permanentmagneten N und S und/oder Spulen Sp, die konzentrisch zur eingezeichneten Achse sind, mit Magnetfeldlinien wie dargestellt, erzielt werden.

Der grundsätzliche Aufbau der in Fig. 2b dargestellten Variante in ähnlich dem in Fig. 2a. Der Unterschied besteht darin, daß keine speziell geformte Gegenelektrode A vorhanden sein muß. Hier dient die gesamte Kammer 1 als Gegenelektrode. Das minimal einstellbare Plasmavolumen wird durch den Wirkungsbereich des Magnetfeldes bestimmt, der z.B. bei Verwendung von Magnetfeldspulen SP durch deren Durchmesser $d_1$ oder durch den Durchmesser $d_2$ der Permanentmagneten N und S variiert werden kann.

Eine scheinbar ähnliche Vorrichtung ist zwar in der DE 38 01 205 C1 beschrieben, bei der eine Magnetanordnung mit senkrecht zur Oberfläche (parallel zum elektrischen Feld im Kathodendunkelraum) verlaufenden B-Linien verwendet wird. Bei dieser bekannten Vorrichtung ist jedoch weder eine speziell geformte Gegenelektrode mit z.B. der zusätzlichen Möglichkeit den Kathodenabstand zu variieren, vorgesehen noch wird mit dem B-Feld das Plasmavolumen variiert.

Fig. 2c zeigt, daß zusätzlich zu dem in den Fig. 2a und 2b dargestellten Aufbau Magnetfelder verwendet werden können, die parallel zur Oberfläche des Substrats Sb verlaufen. Hierdurch kann die Elektronen- und damit auch die Ionenbewegung auf das Substrat zusätzlich beeinflußt werden. In der DE 39 13 463 A1 ist zwar ebenfalls bereits die Verwendung von Magnetfeldern angesprochen, die in etwa parallel zur Oberfläche des Substrats verlaufen können. Bei dem in Fig. 2c dargestellten Ausführungsbeispiel umschließt jedoch das Magnetfeld die Elektroden und insbesondere die Kathode K. Damit kann zusätzlich die Elektronenbewegung im Kathoden-Dunkelraum und damit die DC Self Bias beeinflußt werden:

Eine Erhöhung des parallel zur Wafer-Oberfläche verlaufenden B-Feldes behindert die Elektronenbewegung zum Wafer, der somit schwächer aufgeladen wird. Die Folge hiervon ist eine Reduktion der DC Self Bias und damit der Ionenauftreffenergien. Eine Beeinflußung der Radikalen und Ionenströme ist hierbei nicht vorgesehen. Das geschieht mit dem senkrecht zur Oberfläche verlaufenden B-Feld.

Die Durchmesser der in den Fig. 2a und 2c verwendeten Spulen Sp können in weiten Bereichen variiert werden. Die Spulendurchmesser können z.B. sehr viel größer sein als die Abmessungen der Kammer 1. Auch müssen die Spulenpaare nicht notwendigerweise konzentrisch zu den Kammer- und/ oder Elektrodenachsen sein. In der Regel wird man jedoch bestrebt sein, homogenen Magnetfelder zwischen den Elektroden K und A zu haben. Dazu bieten sich Spulenpaare in Helmholtz-Konfiguration (Spulendurchmesser = Abstand zwischen den Spulen) an.

Selbstverständlich ist es aber auch möglich, anstelle von Spulen Permanentmagnete zu verwenden.

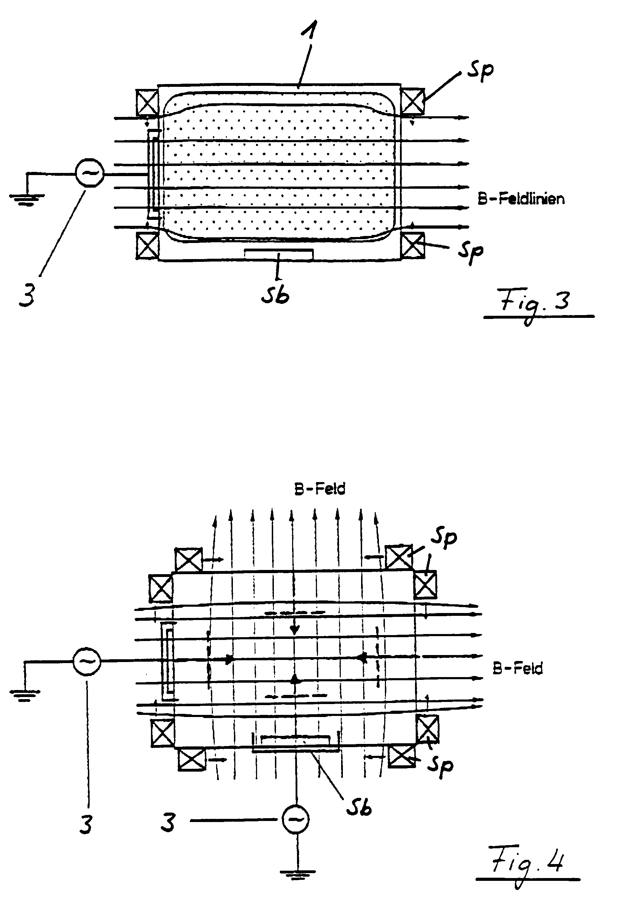

Fig. 3 zeigt ein zweites Ausführungsbeispiel, bei dem die Plasmaeinschnürung die relative Radikalenstrom-dichte, d.h. die relative Stromdichte der reaktiven Neutralteilchen erhöht.

Bei diesem Ausführungsbeispiel verlaufen die Magnetfeldlinien parallel zur Oberfläche des Substrats Sb, so daß die Ionenstromdichten zum Substrat reduziert werden. Der relativ steigende Radikalenanteil fördert die rein chemische Komponente bei der Oberflächenbearbeitung, z.B. für die Erzeugung isotroper Ätzprofile, für die thermische Ablagerung (Deposition) von Schichten auf das Substrat, etc.

Die Leistungseinspeisung erfolgt außerhalb der Substratelektrode durch eine seitlich angebrachte Elektrode E. Durch Einführung eines variablen Magnetfeldes können die Beweglichkeit von Elektronen in Richtung auf das Substrat Sb und damit die Ionenströme auf das Substrat vermindert werden. Die Ionenstromdichten können so kontinuierlich eingestellt werden. Bei geeignet hohen B-Feldern kann der Ionenstrom auf das Substrat vollständig unterdrückt werden, so daß ausschließlich neutrale Teilchen das Substrat erreichen können.

Fig. 4 zeigt ein weiteres Ausführungsbeispiel, das eine Kombination des ersten und zweiten Ausführungsbeispiels darstellt. Dies erlaubt eine größere Variationsbreite in der Prozeßführung von Ionen- zu Neutralteilchen-dominierter Oberflächenbehandlung.

Die Leistungseinkopplung kann über die Substratelektrode K bzw. über eine seitlich angebrachte Elektrode E erfolgen. Eine Umschaltung der Leistungseinkopplung bzw. eine Aufteilung auf die beiden Elektroden ist ebenfalls möglich.

Weiterhin können auch variable Elektrodenabstände für eine zusätzliche Beeinflussung der Plasmaeigenschaften sorgen.

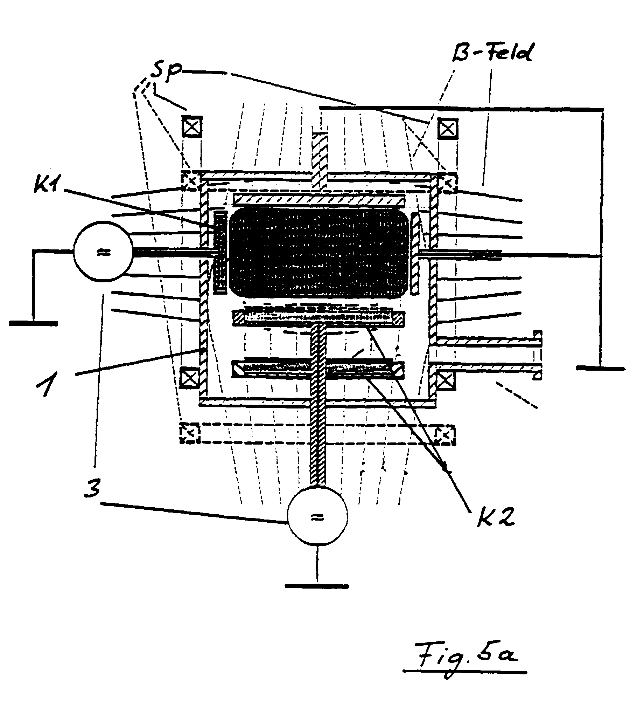

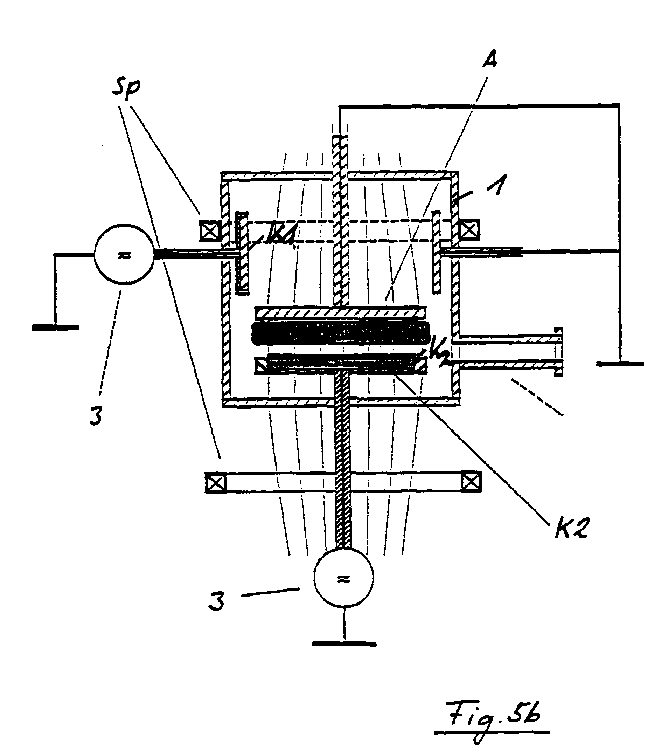

Bevor dies unter Bezugnahme auf die Figuren 5 und 6 näher beschrieben wird, sollen nochmals die erfindungsgemäß vorgesehenen Maßnahmen zusammengefaßt werden, durch die sich eine Reduktion des Plasmasvolumens ergibt:

a) Die Verlustoberflächen für die Ionen verringern sich mit dem B-Feld; dies führt zu einem stärkeren Anstieg der Ionendichte als der Radikalendichte (vgl. auch Gleichung (7)).

Damit ist insbesondere bei sehr kleinem Elektrodenabstand das Verhältnis a = A/Ar sehr stark zu beeinflußen, da sich ohne B-Feld das Plasma bei kleinem Drücken nicht zwischen den Elektroden halten läßt und den gesamten Rezipienten erfüllt. Damit ist A ohne B Feld die gesamte Kammeroberfläche, während mit B-Feld A gleich der Fläche $h\Pi d^2$ ist (h= Elektrodenabstand, d=Durchmesser der Elektrode).

Zusätzlich zu der Ionenverlustoberfläche läßt sich auch die Verlustoberfläche $A_r$ für die Radikalen verändern. Dies wird z.B. durch den Einsatz eines Liners an den Kammerwänden erreicht, der durch Auswahl des geeigneten Materials (hohe Konsumptionsraten für spezielle Radikale) zu einer zusätzlichen Vergrößerung der effektiven Radikalenverlustoberfläche A und damit zu einer weiteren Erhöhung von a führt.

Beispielsweise kann man die F-Radikalendichte beim Siliciumätzen (F ätzt Si spontan) durch einen Liner aus Silicium zusätzlich drücken. Eine weitere Erhöhung der Verlustfläche $A_r$ kann z.B. durch eine entsprechende geometrische Form erreicht werden (z.B. Lamellenstruktur bei einem Heizkörper oder geriffelte Oberfläche etc...)

b) Dadurch, daß das Plasma bei Einsatz eines B-Feldes zwischen den Elektroden gehalten wird, wird bei konstanter ungekoppelter Leistung eine Erhöhung der Leistungsdichten erreicht. Besonders bei kleinen Elektrodenabständen kann damit eine wesentliche Steigerung der Ionisierungsraten (Ionendichten) erreicht werden.

Variable Elektrodenabstände sind zwar prinzipiell bekannt. Die Kombination mit dem erfindungsgemäß vorgesehenen B-Feld macht es jedoch erst möglich, das Plasma auch bei kleinen Drücken und hohen Leistungen im Elektrodenbereich einzuschließen.

Auch die Fig. 4 dargestellten Möglichkeiten mit zwei gepowerten, d.h. jeweils an eine Hochfrequenz-Leistungsquelle angeschlossenen Elektroden ergibt sich eine weitere neue Betriebsart, die in Verbindung mit Fig. 5a und 5b weiter erläutert werden soll:

1: Das Plasma brennt zwischen dem Elektrodenpaar 1, wobei die B-Feld-Achse senkrecht auf der Elektrode K1 steht. Der auf der Elektrode K2 angeordnete Wafer wird bei ausreichendem Abstand vom Plasma in einem ersten Schritt nur einem Radikalenstrom ausgesetzt; hierbei wird die Elektrode K2 nicht gepowert, so daß das Spulenfeld mit einer Achse senkrecht zu K2 ausgeschaltet ist.

2. Die Elektrode K2 kann in einem 2. Schnitt zugeschaltet werden. So können je nach an K2 anliegender Leistung zusätzlich Ionen auf das Substrat gezogen werden; das Spulenfeld mit Achse senkrecht auf K2 kann dabei ein oder ausgeschaltet sein bzw. variiert werden. Die Kathode K1 kann dabei z.B. weiterhin gepowert bleiben oder ausgeschaltet werden.

Hierbei ist es möglich, mit praktisch beliebiger Frequenz zwischen den unterschiedlichen Betriebsmoden umzuschalten. Die beliebigen Schaltmöglichkeiten der Spulenfelder, Kathodenleistungen und Kathodenabstände eröffnen eine ganze Reihe unterschiedlicher Betriebsmoden in einer einzigen Anlage.

Die oben erwähnte Reduktion des Plasmavolumens ist in Abb. 5b noch einmal anschaulich dargestellt.

Bei dem in Fig. 5a dargestellten Ausführungsbeispiel kann ferner die Elektrode K2 zum Umschalten zwischen "Radical"- und "Switch"-Betriebszustand verschoben werden, während bei dem in Fig. 5b dargestellten Ausführungsbeispiel zur Reduktion des Plasmavolumens die Gegenelektrode A verschoben und die Elektrode K1 abgeschaltet wird.

Darüberhinaus kann auch noch die Schalterelektrode zusätzlich gepowert werden.

## Patentansprüche

1. Vorrichtung zur plasmaunterstützten Bearbeitung von Substraten, mit einem Rezipienten, in dem im Plasma gebildete Ionen und reaktive Neutralteilchen (Radikale) auf das Substrat einwirken, und wenigstens einer elektrischen sowie magnetischen Felderzeugungseinrichtung, deren Felder das Ausbreitungsverhalten der im Plasma gebildeten Ionen beeinflussen,
dadurch **gekennzeichnet**, daß zwei senkrecht zueinander angeordnete Elektrodenpaare mit jeweils veränderbarem Elektrodenabstand und zwei Magnetfeldanordnungen vorgesehen sind, deren veränderbare Magnetfelder sich senkrecht schneiden und von denen ein Magnetfeld parallel zur Substratoberfläche orientiert ist.

2. Vorrichtung nach Anspruch 1,
dadurch **gekennzeichnet**, daß zur Variation des Plasmavolumens die Konfiguration des Rezipienten änderbar ist.

**3.** Vorrichtung nach Anspruch 1 oder 2,
dadurch **gekennzeichnet**, daß die Magnetanordnungen eine Helmholz-Konfiguration aufweisen.

**4.** Vorrichtung nach einem der Ansprüche 1 bis 3,
dadurch **gekennzeichnet**, daß das Substrat auf der Kathodenelektrode aufliegt.

**5.** Verwendung einer Vorrichtung nach einem der Ansprüche 1 bis 4 zum Trockenätzen oder Beschichten.

**Claims**

**1.** Apparatus for plasma-enhanced processing of substrates, having a recipient in which ions and reactive neutral particles (radicals), which are generated in the plasma, act on the substrate, and comprising at least one electrical as well as magnetic field generating means producing fields which take an influence on the propagation characteristics of the ions generated in the plasma,
**characterized** in that two pairs of electrodes arranged orthogonally on each other and presenting each a variable electrode spacing, and two magnetic field arrangements are provided whose variable magnetic fields are intersecting orthogonally and whereof one magnetic field is oriented in parallel with the surface of the substrate.

**2.** Apparatus according to Claim 1,
**characterized** in that the configuration of said recipient is alterable for varying the plasma volume.

**3.** Apparatus according to Claim 1 or 2,
**characterized** in that said magnetic arrangements have a Helmholtz configuration.

**4.** Apparatus according to any of Claims 1 to 3,
**characterized** in that said substrate rests on the cathode electrode.

**5.** Application of an apparatus according to any of Claims 1 to 4 for dry etching or layer deposition.

**Revendications**

**1.** Dispositif pour le traitement de substrats à l'aide d'un plasma, comportant un récipient dans lequel des ions et des particules neutres réactives (radicaux) formés dans le plasma agissent sur le substrat, et au moins un dispositif générateur de champ électrique et magnétique dont les champs influencent les propriétés de diffusion des ions formés dans le plasma,
caractérisé en ce que l'on prévoit deux paires d'électrodes perpendiculaires entre elles ayant chacune un écartement des électrodes modifiable, et deux configurations de champ magnétique, dont les champs magnétiques modifiables se coupent à angle droit et dont l'un des champs magnétiques a une orientation parallèle à la surface du substrat.

**2.** Dispositif selon la revendication 1, caractérisé en ce que l'on peut modifier la configuration du récipient pour faire varier le volume de plasma.

**3.** Dispositif selon la revendication 1 ou 2, caractérisé en ce que la disposition des aimants présente une configuration de Helmholz.

**4.** Dispositif selon l'une des revendications 1 à 3, caractérisé en ce que le substrat se trouve sur la cathode.

**5.** Utilisation d'un dispositif selon l'une des revendications 1 à 4 pour l'attaque à sec ou le revêtement.

*Fig. 1*

*Fig. 2a*

_Fig. 2b_

_Fig. 2c_

*Fig. 3*

*Fig. 4*

Fig. 5a

Fig.5b